# NEW EUROPEAN PATENT SPECIFICATION

(11) **EP 0 073 130 B2**
(45) Date of publication and mention of the opposition decision: **12.05.1993**
(45) Mention of the grant of the patent: 02.03.1988
(21) Application number: 82304312.0
(22) Date of filing: 16.08.1982
(51) Int. Cl.: H01L 21/82, H01L 27/112

(54) **Method for manufacturing a mask type Read Only Memory**
Verfahren zur Herstellung eines Nur-Lesespeichers vom Maskentyp
Méthode de fabrication d'une mémoire morte du type masque

(30) Priority: 17.08.1981 JP 128450/81
(43) Date of publication of application: 02.03.1983
(73) Proprietor: KABUSHIKI KAISHA TOSHIBA, Kawasaki-shi, Kanagawa-ken 210 (JP)
(72) Inventor: Shiotari, Yoshihisa, Saiwai-ku Kasawaki-shi Kanagawa-ken (JP)
(74) Representative: Kirk, Geoffrey Thomas

(56) References cited:
- GB-A- 2 017 406
- US-A- 3 576 478
- US-A- 3 914 855
- US-A- 4 080 718
- US-A- 4 129 936
- US-A- 4 235 010
- I.Ruge: "Halbleiter-Technologie", Springer-Verlag, Berlin 1975, pages 298-299

## Description

The present invention relates to Read Only Memories and particularly to a method for manufacturing a mask typ Read Only Memory and to a method of manufacturing the same in which the time for writing data into the ROM is short.

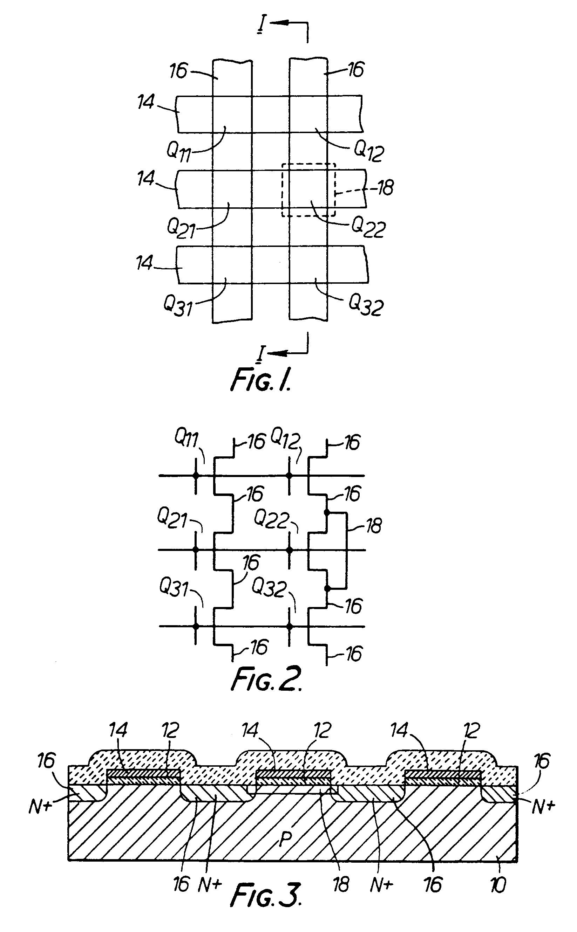

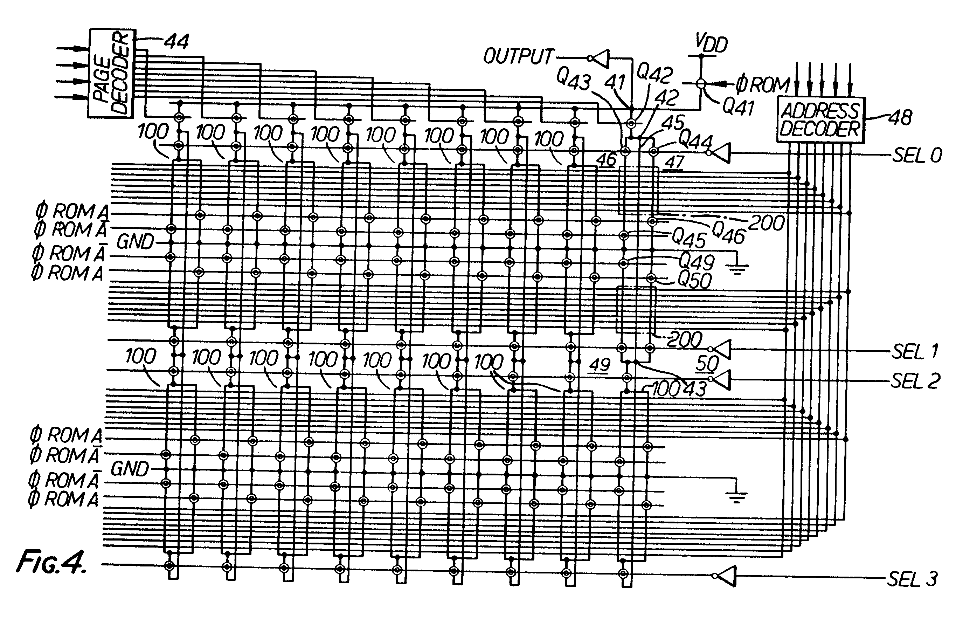

A prior art mask type Read Only Memory is shown in Figures 2 to 3. Agate insulating film 12 and a gate electrode 14 are formed on a P type semiconductor substrate 10. An N⁺ region 16 is formed between gate electrodes 14 by a diffusion process. In the Read Only Memory shown in Figures 1 and 2, MOS transistors Q11, Q21 and Q31 and MOS transistors Q12, Q22 and Q32 are connected in series; load transistors are not shown.

The number of gates provided in the semiconductor devices depends on the specification given by a user. For example, in order to render the MOS transistor Q22 nonoperative, the source and drain of the MOS transistor Q22 are shorted by means of an ion implanted layer 18. However, such a process of ion implantation is performed at an early stage in the wafer making process. This results in a considerable delay before a user will receive the ROMs.

Proposals to cope with this problem are disclosed in United States Patent Specification No. 4,080,718. In these proposals, an impurity is introduced into the channel region by ion implantation in the final stages of the wafer making process, in order to render the MOS transistor into a depletion type. In the final stages, a PSG (phosphosilicate glass) layer is etched away and the impurity is then introduced into the semiconductor substrate by an ion-implantation process. The semiconductor device fabricated is delivered with the implanted regions kept exposed. Accordingly, its reliability is poor. In GB-A-2 017 406, a method of manufacturing a NOR-type ROM is described which may comprise the steps of selectively forming a first insulating layer for a field region and a gate insulating layer, defining the source and drain areas by etching this first insulating layer and subsequent ion implantation, performing a field oxidation to cover source and drain regions with an insulating layer, depositing a polysilicon film over the entire slice, defining gate electrodes by etching this polysilicon film, depositing a thick layer of silicon oxide to insulate the metal level from the polysilicon level and either removing this thick layer only over the gates or over the entire ROM array area. Subsequently metal contacts and interconnections are defined in the usual manner. In the next step programming is performed by using either a further protective oxide layer or a photoresist layer as an implant mask. In the case of using a photoresist layer, a protective oxide layer may be deposited on the ROM area after the programming step. Thus, either the programmed cells are left without a covering of thick protective oxide or all the ROM cells are covered in a similar manner.

The present invention seeks to provide an improved mask type Read Only Memory and a method for manufacturing the same which can produce the completed semiconductor more quickly than previously.

According to the invention there is provided a method of manufacturing a mask type Read Only Memory which has a plurality of MOS transistors connected in series, comprising the steps of:
(a) selectively forming a first insulating layer having a thick portion and a thin portion for field region and a gate insulating layer respectively, on a semiconductor substrate of a first conductivity type;
(b) forming a polysilicon layer on said insulating layer;
(c) forming gate electrodes for the MOS transistors by partially removing said polysilicon layer;
(d) forming regions of a second conductivity type in the substrate, to be source and drain regions of the MOS transistors; using the gate electrodes as a mask, and so that the MOS transistors are connected in series by the second conductivity type regions formed between the gate electrodes;
(e) forming a second insulating film on the semiconductor substrate in which the MOS transistors are formed;
(f) forming a contact hole in the second insulating film to the second conductivity type region of some of the MOS transistors for allowing the formation of outer contact electrodes;
(g) forming outer contact electrodes and bonding pads;
(h) selectively removing at least part of the second insulating film and exposing the gate electrode, source and drain regions of certain of the MOS transistors;
(i) connecting the source and drain regions of the certain MOS transistors by means of a channel region in accordance with a set program, by ion implantation of an impurity;
(j) forming a protective film on said bonding pads, the outer electrodes, and the MOS transistors;
(k) removing said protective film on the bonding pad; and
(I) providing an outer-lead to the bonding pad.

A preferred embodiment of the invention will now be described by way of example and with reference to the accompanying drawings, wherein:
Figure 1 is a schematic plan view of a known semiconductor device;
Figure 2 is an equivalent circuit of the semiconductor device shown in Figure 1;
Figure 3 is a cross-sectional view taken along line I-I on Figure 1;
Figure 4 is a circuit diagram of the mask type Read Only Memory of the preferred embodiment;
Figure 5A is a plan view of a pattern layout illustrating the mask type Read Only Memory corresponding to the circuit of Figure 4;
Figure 5B is a plan view of a pattern layout illustrating a portion of the mask type Read Only Memory cell of Figure 5A;
Figure 5C is an equivalent circuit of the mask type Read Only Memory cell shown in Figure 5B;
Figure 5D is a cross-sectional view taken along line II-II in Figure 5B; and
Figures 6A to 6L are cross-sectional views of a semiconductor substrate schematically illustrating stages in a method of manufacturing a mask type Read Only Memory according to the preferred embodiment.

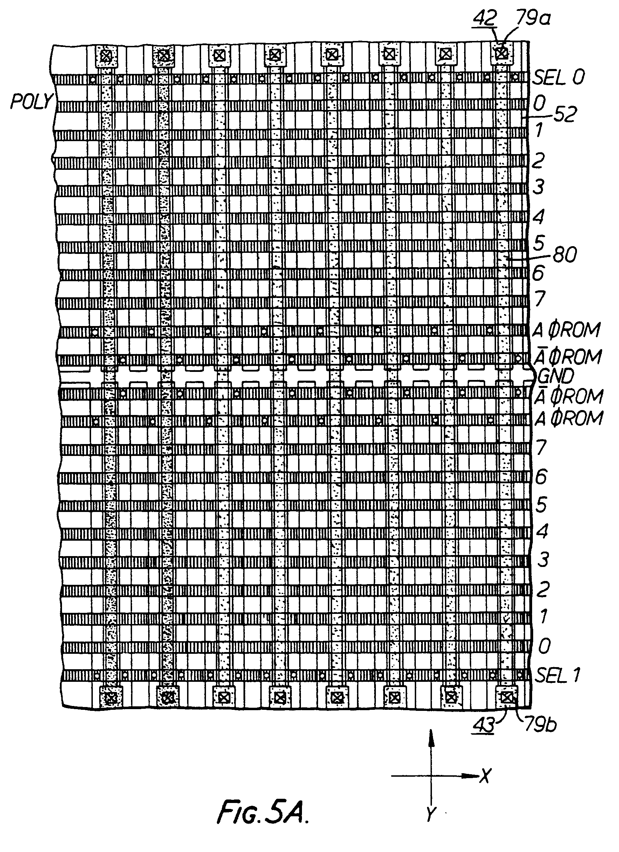

An embodiment of a mask type Read Only Memory according to the preferred embodiment of the present invention and a corresponding method of fabrication will be described with reference to Figures 4, 5A to 5D and 6A to 6L of the drawings, same features being denoted by same reference signs.

Referring to Figure 4, the mask type Read Only Memory consists of a plurality of NAND gate blocks 100 arranged in a row and column matrix, each of the blocks is selectable by the output signals of a page decoder 44 and select signals selₒ to sel₃. Each of the NAND gate blocks 100 includes four NAND gate circuits 46, 47, 49 and 50, one of which is selected by transistors Q45, Q46, Q49, Q50 to which signals φROM·A, φROM·Ä are applied. Predetermined data is permanently written into matrix cell portions 200.

The Read Only Memory has a first and second power source terminals VDD and GND, an output terminal 41, a first branch node 42 and a second branch node 43. A P-channel IGFET Q41 is connected between the first power source terminal VDD and the output terminal 41. An N-channel IGFET Q42 is connected between the output terminal 41 and the first branch node 42. An aluminium wiring electrode 45 interconnects the first branch node 42 and the second branch node 43. A first NAND gate circuit 46 and a second NAND gate circuit 47 are connected between the branch node 42 and GND. N-channel IGFETs Q43, Q44 in the first and second NAND gate circuits 46, 47 select both of the first and second NAND gate circuits 46, 47 simultaneously. N-channel IGFETs Q45, Q46 in the first and second NAND circuits 46, 47 select one of NAND circuits 46 and 47. The matrix cell portions 200 are connected to address decoder 48.

Athird NAND circuit49 and a fourth NAND circuit 50 are arranged in the same manner as first and second NAND circuits 46, 47.

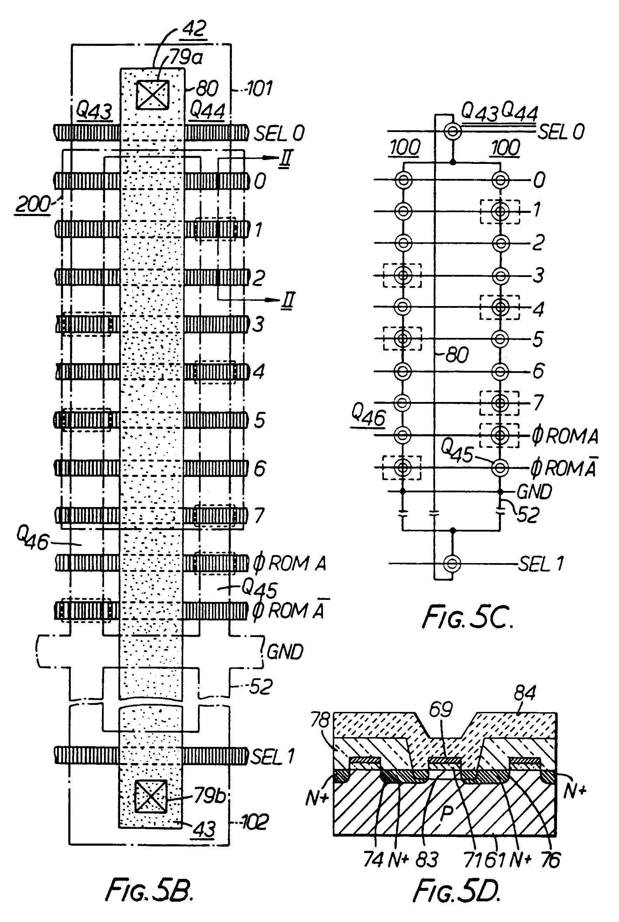

Referring to Figures 5A to 5D, a polysilicon-gate electrode layer is formed by interposing an insulating layer 71 between the P type substrate 61 and the gate electrode layer 69, and N⁺ diffused regions 74, 76 are provided about the channel region. The diffused regions 101, 102 and 52 which constitute regions 74, 76, are formed in a numeral "8" shape (as shown in Figure 5). An insulated aluminium wiring layer 80 is provided in the centre of the "8" shape diffused region, and the aluminium layer 80 connects with the diffused regions 101, 102 at contact holes 79a, 79b. The source and drain regions 74, 76 of selected MOS transistors are connected by implanted channel regions 83.

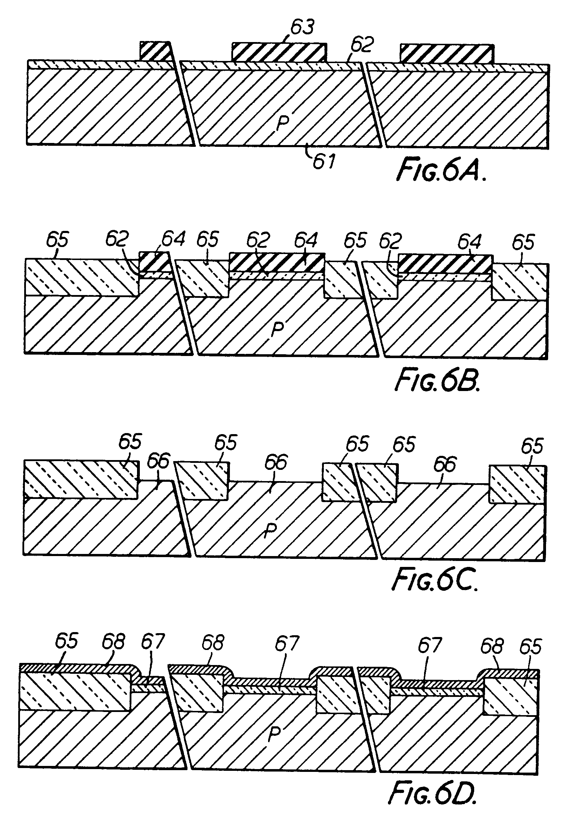

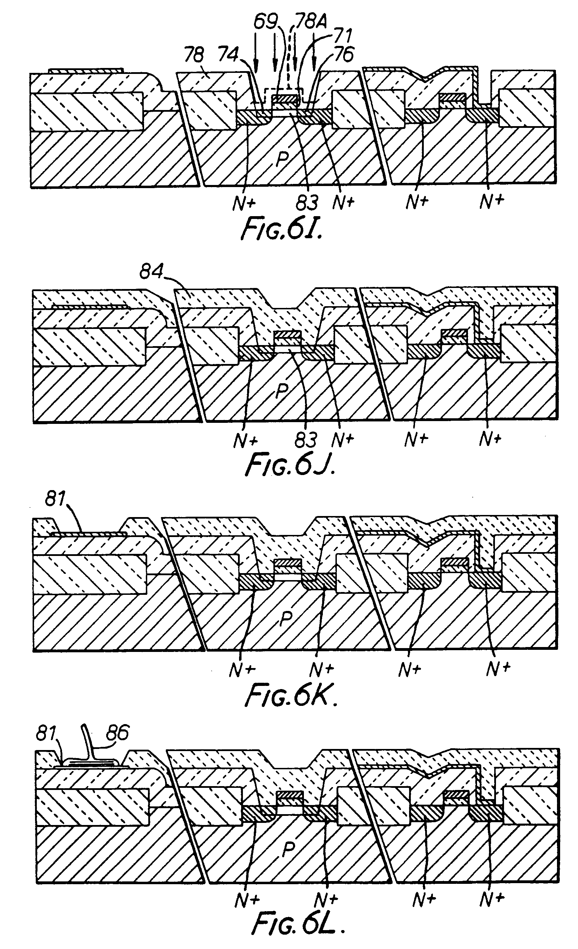

A method of manufacturing a mask type Read Only Memory will be schematically described referring to Figures 6A to 6L.

A thermal oxide film 62 of 100 nm (1000A°) is formed over the entire surface of a P-type silicon substrate 61 which has been doped with boron by the thermal oxidation process. Asilicon nitride layer63 of 300 nm (3000A) is deposited over the entire surface of the oxide film by the CVD process. Some areas of the silicon nitride layer 63 on the substrate 61 where elements are to be formed, are removed by the photoengraving process (Figure 6A). A wet oxidation process is performed in order to form a thick Si0₂ field oxide film 65 of 1 µm (Figure 6B).

As shown in Figure 6C, the remaining silicon nitride masks 64 and the thermal oxide film 62 are removed by the engaraving process. The surface of the semiconductor substrate 61 is thus exposed.

A first thin insulating film (Si0₂) 67 of 50 to 100 nm (500 to 1000A) thickness which serves as a gate oxide film, is formed on the exposed surface 66 of the semiconductor substrate 61. Next, a polysilicon layer 68 of 300 to 400 nm (3000 to 4000A) thickness is deposited over the entire surface by the CVD process (Figure 6D).

The polysilicon layer 68 is subjected to a photoengraving process to form a given pattern, and thus gate electrodes 69, 70 are formed. Using the gate electrodes 69, 70 as a mask, the Si0₂ film 67 is etched away to form gate oxide films 71, 72. Next, a PSG film 73 is deposited over the entire surface by the CVD process. Subsequently, by using the gate oxide films 71, 72 as a mask, phosphorus in the PSG film 73 is diffused into the substrate 61 to form N⁺⁻type drain and source regions 74, 76 (Figure 6E).

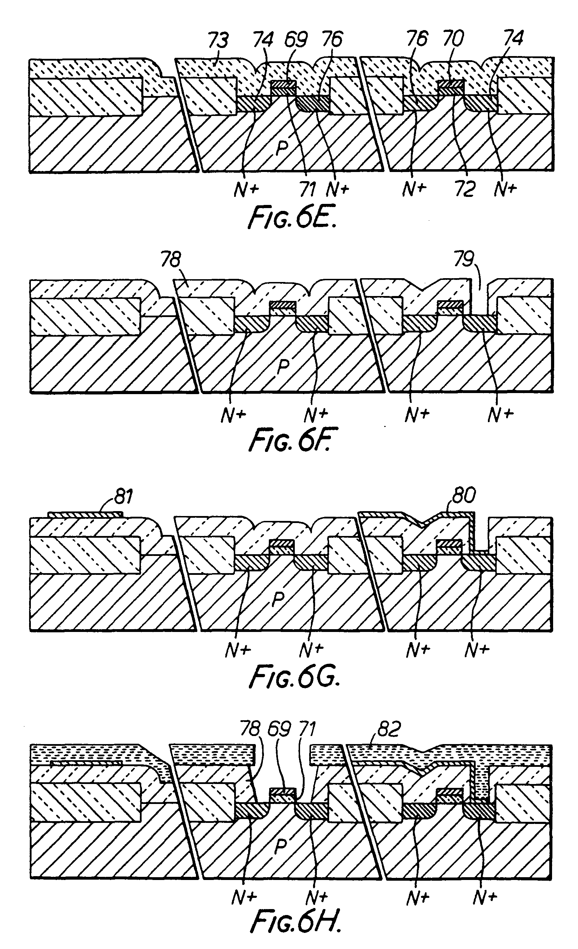

The PSG film 73 is then removed by etching. As shown in Figure 6F, an Si0₂ film 78 of 200 to 600 nm (2000 to 6000A) thickness is formed on the surface as a third insulating layer, by the CVD process. Contact hole 79 for an aluminium wiring electrode 80 is formed in the Si0₂ film 78. Next, aluminium is vapour- deposited over the entire surface and is photoetched to form bonding pads 81 and wiring electrodes 80 at given locations as shown in Figure 6G. Next, a photoresist layer 82 is formed over the surface to provide an etching mask, and the Si0₂ film 78 covering the transistors which are to be of the depletion type in accordance with the information to be stored, is etched away. By using the Si0₂ film 78 (or resist 82) as a mask, impurity divalent phosphorus ions P⁺⁺ of N type, with an energy of 160 KeV, are implanted into a channel region through gate electrodes 69 and gate oxide film 71 (and the Si0₂ 78A). An N type implanted channel region 83 connecting the source and drain of the transistor is thus formed, and the transistor is rendered a depletion type (Figure 61). Next, as shown in Figure 6J, a protective film 84 such as a BPSG (boron-doped phospho-silicate glass) film or PSG film or silicon nitride film, of 500 to 700 nm (5000 to 7000A) thickness is deposited over the surface by the plasma CVD method. The surface protective film 84 is formed with concave regions corresponding to the depletion type transistors which represent the stored information. Accordingly, it is possible to check the stored information from the outer configuration of the device. Next, as shown in Figure 6K, a bonding pad 81 for an outer-lead is exposed, and the chip fabricating process is completed. As shown in Figure 6L, an outer-lead 86 made from aluminium is connected to the bonding pad 81.

In the described method of making a mask type Read Only Memory, the ion implantation into the channel region to form a depletion type MOS transistor to determine the memory content of the device is performed at a late stage of the process. The fabrication process steps up to the deposition of the Si0₂ film following the formation of the MOS transistors may be performed in advance before the memory contents are determined. After the memory contents are determined in accordance with a customer's requirements, a mask for the memory contents is obtained, and the ion implantation into the above- mentioned channel regions and the remaining steps of the process are performed. Accordingly the period from when the memory contents are specified by a customer until the products storing those contents are completed is considerably reduced. Further, because the protective film covering each depletion type transistor in the memory region is concave in shape the contents stored may be checked externally.

## Claims

1. A method of manufacturing a mask type Read Only Memory comprising the steps of:
I forming a plurality of MOS transistors connected in series in a semiconductor substrate of a first conductivity type by
(a) selectively forming a first insulating layer having a thick portion (65) and a thin portion (67) for a field region and a gate insulating layer, respectively, on the semiconductor substrate,
(b) forming a polysilicon layer (68) on said insulating layer,
(c) forming gate electrodes (69, 70) for the MOS transistors by partially removing said polysilicon layer,
(d) using the gate electrodes as a mask forming regions (74, 76) of a second conductivity type in the substrate to be source and drain regions of the MOS transistors, said second conductivity type regions of adjacent transistors being connected so that the MOS transistors are connected in series, and
(e) forming a second insulating film (78) on the surface of the substrate in which the MOS transistors are formed;
II
(a) forming a contact hole (79) in the second insulating film to expose the second conductivity type region of some of the MOS transistors,
(b) forming an aluminium contact electrode on the insulating film away from the transistors and which makes contact with the region of second conductivity type through said contact holes,
(c) forming bonding pads (81);
III
(a) selectively removing at least part of the second insulating film (78) to expose the gate electrode, source and drain regions of certain of the MOS transistors,
(b) connecting the source and drain regions of each of said exposed MOS transistors by means of a channel region (83) by ion implantation of an impurity of the second conductivity type; and
IV forming a protective film (84) on said bonding pads, outer electrode (80) and the MOS transistors, removing the protective film (84) from the bonding pads and providing an outer lead (86) to each of the bonding pads.

2. A method as claimed in claim 1, wherein step for forming the thick field insulating layer on the semiconductor substrate comprises the steps of:
(a) forming a thermal oxide layer (62) on the semiconductor substrate (61);
(b) selectively forming a silicon nitride film (65) on the thermal oxide layer;
(c) forming a first thick insulating layer (65) on the semiconductor substrate by oxidizing the semiconductor substrate using the silicon nitride film as a mask; and
(d) removing said silicon nitride layer and the thermal oxide layer.

3. A method as claimed in claim 1 or claim 2, wherein the step of forming regions of a second conductivity type to the source and drain regions of the MOS transistors comprises the steps of:
(a) forming gate insulating films (71, 72) in the MOS transistors by etching the thin insulating film (67) using the silicon gate (69, 70) as an etching mask;
(b) forming an impurity source film (73) on the semiconductor substrate, and
(c) diffusing the impurities in the impurity source film into the semiconductor substrate so as to form source and drain regions (74, 76).

4. Amethod as claimed in claim 1, wherein said step for selectively removing the insulating film over the source regions and drain regions of said certain MOS transistors, includes the steps of: leaving a thin film (78A) of the second insulating film (78) on the silicon gate electrodes (69) of at least some of said certain MOS transistors.

## Patentansprüche

1. Verfahren zur Herstellung eines Nur-Lesespeichers vom Maskentyp, gekennzeichnet durch folgende Schritte:
I Ausbilden einer Vielzahl von in Reihe geschalteten MOS-Transistoren in einem Halbleitersubstrat eines ersten Leitungstyps durch
a) selektives Ausbilden einer ersten Isolierschicht mit einem dicken Abschnitt (65) und einem dünnen Abschnitt (67) für einen Feldbereich und eine Gate-Isolierschicht auf dem Halbleitersubstrat,
b) Ausbilden einer Polysiliciumschicht (68) auf der Isolierschicht,
c) Ausbilden von Gate-Elektroden (69, 70) für die MOS-Transistoren durch teilweises Entfernen der Polysiliciumschicht,
d) Verwenden der Gate-Elektroden als Maske zum Ausbilden von Bereichen (74, 76) eines zweiten Leitfähigkeitstyps im Substrat zur Schaffung von Source- und Drain-Bereichen der MOS-Transistoren, wobei die Bereiche des zweiten Leitungstyps so verbunden sind, daß die MOS-Transistoren in Reihe geschaltet werden,
e) Ausbilden eines zweiten Isolierfilms (78) auf der Oberfläche des Halbleitersubstrats, in dem die MOS-Transistoren ausgebildet werden,
11
a) Ausbilden eines Kontaktloches (79) im zweiten Isolierfilm (78), um den Bereich des zweiten Leitfähigkeitstyps einiger der MOS-Transistoren freizulegen,
b) Ausbilden einer Aluminium-Kontakt-Elektrode auf dem Isolierfilm entfernt von den Transistoren, welche über die Kontaktlücke einen Kontakt mit dem Bereich des zweiten Leitungstyps herstellt,
c) Ausbilden von Bondstellen (81),
III
a) selektives Entfernen wenigstens eines Teiles des zweiten Isolierfilmes (78) zum Freilegen der Gatterelektrode, der Source-und Drain-Bereiche bestimmter MOS-Transistoren,
b) Verbinden der Source- und Drain-Bereiche jeder der freigelegten MOS-Transistoren mit Hilfe eines Kanalbereiches (83) durch lonenimplantation eines Fremdkörpers des zweiten Leitungstyps,
IV Ausbilden eines Schutzfilmes (84) auf den Bondstellen (81), den Außenelektroden (80) und den MOS-Transistoren, Entfernen des Schutzfilmes (84) von den Bondstellen (81) und Anbringen einer Außenleitung (86) an jede Bondstelle (81).

2. Verfahren nach Anspruch 1, bei dem das Ausbilden der dicken Feldisolierschicht auf dem Halbleitersubstrat folgende Verfahrensschritte aufweist :
a) Ausbilden einer thermischen Oxidschicht (62) auf dem Halbleitersubstrat (61),
b) reflektive Ausbildung eines Siliciumnitridfilmes (63) auf der thermischen Oxidschicht,
c) Ausbilden einer ersten dicken Isolierschicht (65) auf dem Halbleitersubstrat durch Oxidation des Halbleitersubstrates, indem der Siliciumnitridfilm als Maske verwendet wird, und
d) Entfernen der Siliciumnitridschicht und der thermischen Oxidschicht.

3. Verfahren nach Anspruch 1 oder 2, bei dem das Ausbilden der Bereiche des zweiten Leitfähigkeitstyps für die Source- und Drain-Bereiche der MOS-Transistoren folgende Verfahrensschritte aufweist :
a) Ausbilden von Gate-Isolierfilmen (71, 72) in den MOS-Transistoren durch Ätzen des dünnen Isolierfilmes (67), indem das Silicium-Gate (69, 70) als Ätzmaske verwendet wird,
b) Ausbilden eines Fremdkörper-Sourcefilmes (73) auf dem Halbleitersubstrat, und
c) Eindiffundieren der Fremdkörper im Fremdkörper-Source-film in das Halbleitersubstrat zur Bildung von Source- und Drain-Bereichen (74, 76).

4. Verfahren nach Anspruch 1, bei dem das selektive Entfernen des Isolierfilmes über den Source-Bereichen und den Drain-Bereichen der bestimmten MOS-Transistoren folgenden Verfahrensschritt aufweist : Belassen eines dünnen Filmes (78A) des zweiten Isolierfilmes (78) auf den Silicium-Gate-Elektroden (69) wenigstens einiger der bestimmten MOS-Transistoren.

## Revendications

1. Procédé de fabrication d'une mémoire morte ou mémoire ROPM du type à masque qui consiste :
I) à former une série de transistors MOS connectés en série à un substrat semi-conducteur ayant un premier mode de conduction.
a) à former une première couche isolante ayant une partie épaisse (65) et une partie mince (67) pour une région de champ et une couche isolante de porte, sur un substrat semi-conducteur ;
b) à former une couche de polysilicium (68) sur ladite couche isolante ;
c) à former des électrodes de porte (69, 70) pour les transistors MOS en enlevant partiellement ladite couche de polysilicium;
d) à utiliser les électrodes de porte comme masques pour former des régions (74, 76) ayant un second mode de conduction dans le substrat pour être des régions de source et de drain des transistors MOS, ces régions ayant ce second mode de conduction de transistors adjacents comme les transistors MOS connectés en série ;
e) à former une seconde pellicule isolante (78) sur le substrat semi-conducteur dans lequel les transistors MOS sont formés.
Il)
a) à former un trou de contact (79) dans la seconde pellicule isolante (78) pour exposer la région ayant le second mode de conduction de certains transistors MOS .
b) à former une électrode de contact en aluminium dans la pellicule isolante, loin des transistors et qui fait contact avec la région du second mode de conduction à travers lesdits trous de contact ;
c) à former des pastilles de connexion (81).
III)
a) à enlever, sélectivement, au moins une partie de la seconde pellicule isolante (78) pour découvrir les régions d'électrode de porte, de source et de drain de certains transistors MOS ;
b) à connecter les régions de source de drain de chacun de ces transistors MOS au moyen d'une région de canal (83) par une implantation d'ions d'une impureté du second mode de conduction ;
IV) à) former une pellicule protectrice (84) sur les pastilles de connexion (81°, sur les électrodes extérieures (80) et les transistors MOS, à enlever la pellicule de protection (84) des pastilles de connexion (81) et à fixer un conducteur extérieur (86) à chacune desdites pastilles de protection.

2. Procédé selon la revendication 1, caractérisé en ce que la procédure pourformer la couche isolante épaisse sur le substrat semi-conducteur comprend les étapes suivantes :
a) on forme une couche d'oxyde thermique (62) sur le substrat semi-conducteur (61) ;
b) on forme sélectivement une pellicule de nitrure de silicium (61) sur la couche d'oxyde thermique ;
c) on forme une première couche isolante épaisse (65) sur le substrat semi-conducteur en oxydant ce dernier en utilisant la pellicule de nitrure de silicium comme masque ; et
d) on enlève ladite couche de nitrure de silicium et la couche d'oxyde thermique.

3. Procédé selon la revendication 1 ou 2, caractérisé en ce que la procédure pourformer les régions ayant le second mode de conduction des régions de source et de drain des transistors MOS consiste:
a) à former des pellicules isolantes de porte (71,72) dans les transistors MOS en décapant la mince pellicule isolante (67) en utilisant les portes de silicium (69, 70) comme masques de décapage ;
b) à former une pellicule-source d'impuretés (73) sur le substrat semi-conducteur; et
c) à diffuser les impuretés de ladite source dans le substrat semi-conducteur afin de former les régions de source et de drain (74,76).

4. Procédé selon la revendication 1, caractérisé en ce que la procédure pour enlever sélectivement la pellicule isolante sur les régions de source et de drain de certains transistors MOS, comprend les étapes consistant à laisser une mince couche (78A) de la seconde pellicule isolante (78) sur les électrodes de porte (69) de quelques uns, au moins, des transistors MOS.
